# EUROPÄISCHE PATENTSCHRIFT

(11) **EP 3 052 988 B1**
(45) Veröffentlichungstag und Bekanntmachung des Hinweises auf die Patenterteilung: **30.08.2017**
(21) Anmeldenummer: 14777324.6
(22) Anmeldetag: 30.09.2014
(51) Int. Cl.: G03F 7/20

(54) **VORRICHTUNG UND VERFAHREN ZUR IN-LINE HERSTELLUNG VON FLEXODRUCKPLATTEN**
DEVICE AND METHOD FOR THE IN-LINE PRODUCTION OF FLEXOGRAPHIC PRINTING PLATES
DISPOSITIF ET PROCÉDÉ DE FABRICATION DE CLICHÉS FLEXOGRAPHIQUES EN LIGNE

(30) Priorität: 30.09.2013 EP 13186585
(43) Veröffentlichungstag der Anmeldung: 10.08.2016
(73) Patentinhaber: Flint Group Germany GmbH, 70469 Stuttgart (DE)
(72) Erfinder: STEBANI, Uwe, 67592 Flörsheim-Dalsheim (DE); DIETZ, Gernot, 67304 Eisenberg (DE)
(74) Vertreter: Schuck, Alexander
(86) Internationale Anmeldenummer: PCT/EP2014/070865
(87) Internationale Veröffentlichungsnummer: WO 2015/044437

(56) Entgegenhaltungen:
- EP-A2- 2 317 387
- WO-A2-2004/111725
- WO-A2-2008/135865
- DE-A1-102010 031 527
- US-A- 5 552 262
- US-A1- 2004 081 908
- US-A1- 2008 280 227
- US-A1- 2009 272 286

## Beschreibung

Die vorliegende Erfindung betrifft eine Vorrichtung zur automatisierten Durchführung von Rückseitenvorbelichtung, Hauptbelichtung sowie Entwickeln digital bebilderbarer Flexodruckelemente. Die Erfindung betrifft weiterhin ein Verfahren zur Herstellung von Flexodruckplatten ausgehend von digital bebilderbaren Flexodruckelementen unter Verwendung der besagten Apparatur.

Digital bebilderbare Flexodruckelemente sind prinzipiell bekannt. Sie umfassen mindestens einen dimensionsstabilen Träger, eine fotopolymerisierbare Schicht sowie eine digital bebilderbare Schicht. Bei der digital bebilderbaren Schicht kann es sich beispielsweise um eine laserablatierbare Schicht, um eine mittels Ink-Jet-Drucker beschreibbare Schicht oder um eine thermographische Schicht handeln, wobei laserablatierbare Schichten, auch LAMS (laserablatierbare Maskenschichten) genannt, am gebräuchlichsten sind.

Die Herstellung von Flexodruckformen ausgehend von fotopolymerisierbaren, digital bebilderbaren Flexodruckelementen erfolgt mittels eines mehrstufigen Prozesses unter Verwendung entsprechender Vorrichtungen für jeden Verfahrensschritt.

Zunächst wird eine Maske in die digital bebilderbare Schicht unter Verwendung eines IR-Lasers eingeschrieben. Es kann sich hierbei um Laserapparaturen mit rotierender Trommel handeln oder um Flachbettapparaturen.

Nach dem Einschreiben der Maske wird das Flexodruckelement durch die gebildete Maske hindurch mit UV-Strahlung bzw. UV/VIS-Strahlung belichtet. Die fotopolymerisierbare Schicht polymerisiert in den von der Maske nicht mehr abgedeckten Bereichen, während in den abgedeckten Bereichen keine Polymerisation erfolgt. Hierfür werden UV-Belichter verwendet, welche verschiedene UV-Quellen umfassen können, beispielsweise UV-Röhren oder UV-LEDs.

Nach der Belichtung werden die Reste der Maske sowie die nicht polymerisierten Anteile der fotopolymerisierbaren Schicht entfernt. Dies kann unter Verwendung von einem oder mehreren Lösemitteln oder auch thermisch erfolgen. Zum Auswaschen mittels Lösemittel werden spezielle Auswaschgeräte, z.B. Bürstenwascher verwendet. Zum thermischen Entwickeln können Geräte verwendet werden, bei denen ein saugfähiges Vlies mittels einer beheizten Rolle an die belichtete Schicht gedrückt wird.

Bei Verwendung von Lösemitteln zum Entwickeln der Platte schließt sich ein Trockenschritt in einem Trockner an.

Üblicherweise wird die Oberfläche der erhaltenen Flexodruckform nach dem Trocknen nachbehandelt, beispielsweise durch Belichten der Oberfläche mit UVA- und/oder UVC-Strahlung. Hierfür werden wiederum entsprechende Belichtungsapparaturen verwendet.

Zur Herstellung von Flexodruckformen müssen die Vorrichtungen zur Durchführung der jeweiligen Verfahrensschritte vor jedem Verfahrensschritt manuell mit dem Flexodruckelement beladen werden. Nach der Durchführung des Verfahrensschrittes muss das verarbeitete Flexodruckelement der Vorrichtung manuell entnommen und dem jeweils nachfolgenden Verfahrensschritt zugeführt werden. Wegen der wiederholt notwendigen manuellen Eingriffe in das Verfahren ist die Herstellung von Flexodruckformen aufwändig.

Es sind daher Vorrichtungen vorgeschlagen worden, die die Durchführung verschiedener Verfahrensschritte in einer Apparatur miteinander kombinieren und somit die Zahl manueller Eingriffe verringern.

US 5,919,378 offenbart eine Vorrichtung zur automatisierten Verarbeitung belichteter Flexo-Runddruckformen durch Auswaschen, Trocknen und Nachbehandeln. Das Belichten ist nicht in die Vorrichtung integriert, sondern wird mittels einer separaten Vorrichtung vorgenommen. Nach dem Belichten werden die belichteten Runddruckformen manuell in die beschriebene Verarbeitungsvorrichtung geladen.

WO 2012/010459 A1 offenbart ein Verfahren zur Herstellung von Flexodruckformen, welches eine zweistufige Belichtung umfasst. In einem ersten Belichtungsschritt erfolgt eine Belichtung mit aktinischem Licht einer Intensität ≥ 100 mW/cm² aus einer Mehrzahl von UV-LEDs und in einem zweiten Schritt erfolgt eine Belichtung mit einer Intensität < 100 mW/cm² mit einer von UV-LEDs verschiedenen Strahlungsquelle, bevorzugt einer UV-Röhre. WO 2012/010459 A1 offenbart weiterhin eine Vorrichtung zur in-line Produktion von Flexodruckelementen, welche mindestens eine erste Belichtungseinheit mit UV-LEDs, eine zweite Belichtungseinheit mit einer von LEDs verschiedenen Strahlungsquelle, bevorzugt einer UV-Röhre, eine Auswascheinheit und eine Trocknungseinheit umfasst. Weiterhin umfasst die beschriebene Vorrichtung Transporteinheiten, welche die beschriebenen Einheiten miteinander verbinden. Die Vorrichtung kann optional noch eine Einheit zur digitalen Bebilderung der Flexodruckelemente, eine Nachbehandlungseinheit sowie eine Ausgabeeinheit für die erhaltenen Flexodruckplatten umfassen. Die Schrift offenbart jedoch keine konstruktiven Einzelheiten zur beschriebenen Vorrichtung.

Die beschriebene Vorrichtung hat eine Reihe von Nachteilen.

Erstens verursacht ein zweistufiger Belichtungsprozess unter Verwendung von verschiedenen UV-Quellen höheren apparativen Aufwand als ein einstufiger Belichtungsprozess.

Zweites sieht die vorgeschlagene Vorrichtung keine Rückseitenvorbelichtung vor. Unter "Rückseitenvorbelichtung" versteht der Fachmann, dass die fotopolymerisierbare, reliefbildende Schicht eines Flexodruckelements vor der eigentlichen Hauptbelichtung von der Rückseite aus, d.h. durch den dimensionsstabilen Träger hindurch, kurz mit UV-Licht vorbelichtet wird. Es versteht sich von selbst, dass der dimensionsstabile Träger hierfür zumindest eine gewisse Transparenz für UV-Strahlung haben muss. Bei UVundurchlässigen Trägern wie beispielsweise metallischen Trägern ist eine Rückseitenvorbelichtung naturgemäß nicht möglich. Im Zuge der Rückseitenvorbelichtung wird in der reliefbildenden Schicht ein polymerisierter Bereich erzeugt, mit dem die Relieftiefe der Nichtbildbereiche auf ein gewünschtes Maß eingestellt werden kann. Dadurch werden insbesondere feine Reliefelemente besser versockelt und damit stabiler beim Drucken. Die Rückseitenvorbelichtung muss bei sehr dünnen Flexodruckelementen nicht unbedingt durchgeführt werden, ist aber bei Flexodruckelementen einer Dicke von mehr als 1 mm (diese Angabe bezieht sich in üblicher Art und Weise auf die Summe der Dicken von dimensionsstabiler Trägerfolie und fotopolymerisierbarer Schicht) kaum verzichtbar, wenn gravierende Nachteile bei den Druckeigenschaften der erhaltenen Flexodruckform vermieden werden sollen. In der von WO 2012/010459 A1 vorgeschlagenen Apparatur lassen sich daher zumindest dickere Flexodruckelemente nicht mit befriedigendem Ergebnis verarbeiten.

Drittens bleibt bei der beschriebenen Vorrichtung unberücksichtigt, dass die Geschwindigkeiten, mit denen Flexodruckelemente in den einzelnen Verarbeitungsschritten verarbeitet werden können, stark von der Natur der eingesetzten Flexodruckelemente abhängen. Insbesondere hängt die Auswaschgeschwindigkeit ganz erheblich von der Dicke der reliefbildenden Schicht ab. So lassen sich belichtete, dünne Flexodruckelemente in der Regel mit Geschwindigkeiten von bis zu 900 mm/min auswaschen, während die Auswaschgeschwindigkeiten bei dicken Flexodruckelementen erheblich geringer sind, und beispielsweise nur ca. 50 mm/min betragen können. Eine Reduzierung der Verarbeitungsgeschwindigkeit um den Faktor 10 bei dicken Platten würde bei der Belichtung zu einer um den Faktor 10 erhöhten Belichtungszeit und somit zu völlig unbefriedigenden Belichtungsergebnissen führen. Es ist also nicht möglich, in der vorgeschlagenen Vorrichtung unterschiedliche Plattenstärken zu verarbeiten, sondern es müssen für unterschiedliche Plattenstärken unterschiedliche Vorrichtungen bereitgehalten werden, was vom Markt nicht akzeptiert wird.

Auch die thermische Entwicklung von belichteten Flexodruckelementen dauert umso länger, je dicker die reliefbildende Schicht ist.

Aufgabe der Erfindung war es, eine verbesserte Vorrichtung zur in-line-Belichtung von Flexodruckelementen bereit zu stellen, mit der auch unterschiedlich dicke Flexodruckelemente mit zufriedenstellenden Ergebnissen verarbeitet werden können. Dementsprechend wurde eine Vorrichtung zur Herstellung von Flexodruckplatten ausgehend von digital bebilderten Flexodruckelementen umfassend mindestens eine UV-transparente, dimensionsstabile Trägerfolie, eine fotopolymerisierbare, reliefbildende Schicht sowie eine digital bebilderte Schicht gefunden, wobei die Vorrichtung mindestens die folgenden Baueinheiten umfasst:
- eine Transportvorrichtung (1) zum Transportieren der Flexodruckelemente durch die Vorrichtung,
- eine unterhalb der Transportvorrichtung angeordnete Belichtungseinheit (6) zur Rückseitenvorbelichtung der Flexodruckelemente mittels UV-Strahlung, umfassend mindestens eine in der Leistung regelbare UV-Quelle,
- eine oberhalb der Transportvorrichtung angeordnete Belichtungseinheit (5) zur Hauptbelichtung der Flexodruckelemente mittels UV-Strahlung, umfassend mindestens eine in der Leistung regelbare UV-Quelle, mit der Maßgabe, dass die Einheit (5) in Transportrichtung hinter der Einheit (6) angeordnet ist oder dass die Einheiten (5) und (6) einander gegenüber liegend angeordnet sind,
- eine in Transportrichtung hinter den Belichtungseinheiten angeordnete Entwicklungseinheit (8) zum Entfernen der Reste der digital bebilderten Schicht sowie der nicht polymerisierten Anteile der reliefbildenden Schicht,
- eine Steuerungseinheit (9) zum Regeln der Leistung der Einheit (6) zur Rückseitenvorbelichtung, der Leistung der Einheit (5) zur Hauptbelichtung und der Transportgeschwindigkeit der Transportvorrichtung.

In einer bevorzugten Ausführungsform der Vorrichtung handelt es sich bei der Entwicklungseinheit (8) um eine Auswascheinheit zum Entfernen der Reste der digital bebilderbaren Schicht sowie der nicht polymerisierten Anteile der reliefbildenden Schicht unter Verwendung von Auswaschmitteln.

Weiterhin wurde ein Verfahren zur Herstellung von Flexodruckplatten ausgehend von digital bebilderbaren Flexodruckelementen gefunden, wobei die digital bebilderbaren Flexodruckelemente mindestens eine UV-transparente, dimensionsstabile Trägerfolie, eine fotopolymerisierbare, reliefbildende Schicht sowie eine digital bebilderbare Schicht umfassen und das Verfahren mindestens die folgenden Verfahrensschritte umfasst:
(A) Einschreiben einer Maske in die digital bebilderbare Schicht,
(B) Rückseitenvorbelichtung des bebilderten Flexodruckelements mit UV- bzw. UV-Strahlung durch die UV-transparente Trägerfolie hindurch,
(C) Belichten des bebilderten Flexodruckelements mit UV- bzw. UV-Strahlung durch die gebildete Maske hindurch,
(D) Entfernen der Reste der digital bebilderbaren Schicht sowie der nicht polymerisierten Anteile der reliefbildenden Schicht,
wobei man mindestens die Verfahrensschritte (B), (C) und (D) unter Verwendung der genannten Vorrichtung durchführt, und wobei man die Geschwindigkeit der Transportvorrichtung mittels der Steuerungseinheit (9) auf einen festen Wert einstellt und die Leistung der UV-Quelle zur Rückseitenvorbelichtung sowie die Leistung der UV-Quelle zur Hauptbelichtung entsprechend der gewählten Transportgeschwindigkeit einstellt.

In einer bevorzugten Ausführungsform des Verfahrens wird Verfahrensschritt (D) unter Verwendung von Auswaschmitteln durchgeführt, und die erhaltene Flexodruckplatte wird in einem weiteren Verfahrensschritt (E) getrocknet.

Verzeichnis der Abbildungen:
- Abbildung 1: Schematische Darstellung einer Ausführungsform der erfindungsgemäßen Vorrichtung, umfassend Module zur Rückseitenvorbelichtung, Hauptbelichtung, und Auswaschen, Rückseitenvorbelichtung und Hauptbelichtung erfolgen gleichzeitig
- Abbildung 2: Schematische Darstellung einer weiteren Ausführungsform der erfindungsgemäßen Vorrichtung, umfassend Module zur Rückseitenvorbelichtung, Hauptbelichtung, und Auswaschen, Rückseitenvorbelichtung erfolgt zuerst und dann Hauptbelichtung
- Abbildung 3: Ausführungsform der Vorrichtung mit zusätzlicher Vorrichtung zum Streuen von UV-Licht
- Abbildung 4: Schematische Darstellung einer Ausführungsform der Transportvorrichtung

Zu der Erfindung ist im Einzelnen das Folgende auszuführen:
Im Folgenden werden die Begriffe "Flexodruckplatte", "Flexodruckform" oder "Klischee" für eine bereits vernetzte, druckfertige Druckform verwendet. Der Begriff "Flexodruckelement" wird in üblicher Art und Weise für das fotopolymerisierbare Ausgangsmaterial verwendet, welches zur Herstellung von Flexodruckformen bzw. Flexodruckplatten eingesetzt wird.

### Flexodruckelemente

Die erfindungsgemäße Vorrichtung wird in Verfahren zum Verarbeiten plattenförmiger, digital bebilderbarer Flexodruckelemente zu Flexodruckplatten eingesetzt. Das Entwickeln der belichteten Flexodruckelemente kann unter Verwendung von Auswaschmitteln oder thermisch vorgenommen werden.

Plattenförmige, digital bebilderbare Flexodruckelemente sind dem Fachmann prinzipiell bekannt, und sie sind kommerziell erhältlich. Beispiele derartiger Flexodruckelemente sind beispielsweise in US 5,262,275 oder EP-A 1 069 475 beschrieben.

Die digital bebilderbaren Flexodruckelemente umfassen mindestens eine dimensionsstabile Trägerfolie, eine reliefbildende, fotopolymerisierbare Schicht sowie eine digital bebilderbare Schicht. Sie können darüber hinaus selbstverständlich noch weitere Schichten umfassen, wie beispielsweise Klebeschichten, Sauerstoff- Sperrschichten oder eine Schutzfolie auf der digital bebilderbaren Schicht.

Die Trägerfolie weist eine Dicke von 100 bis 200 µm auf. In aller Regel handelt es sich um eine Trägerfolie aus einem für UV-Licht zumindest teilweise transparenten Material, um die Rückseitenvorbelichtung des Flexodruckelements zu erlauben. Beispiele derartiger Materialien umfassen Folien aus Polymeren wie beispielsweise Polyethylenterephalat, Polybutylenterephalat, Polyethylennaphthalat oder Polycarbonat. Geeignet sind insbesondere PET-Folien mit einer Dicke von 100 bis 200 µm. Denkbar insbesondere für dünne Flexodruckelemente sind weiterhin Folien aus Metallen, wie beispielsweise Aluminiumfolien. In diesem Falle ist aber keine Rückseitenvorbelichtung mehr möglich. Die fotopolymerisierbare, reliefbildende Schicht umfasst mindestens ein elastomeres Bindemittel, ein ethylenisch ungesättigtes Monomer sowie einen Fotoinitiator oder ein Fotoinitiatorsystem. Neben den genannten Komponenten können optional können noch weitere Komponenten wie beispielsweise Weichmacher vorhanden sein. Bevorzugt handelt es sich um eine in organischen Auswaschmitteln lösliche Schicht, aber selbstverständlich können auch Flexodruckelemente mit wasserlöslichen, reliefbildenden Schichten in der erfindungsgemäßen Vorrichtung verarbeitet werden. Bei den elastomeren Bindemitteln kann es sich beispielsweise um thermoplastisch-elastomere Blockcopolymere, beispielsweise Styrol-Butadien- oder Styrol-Isopren-Blockcopolymere handeln. Die reliefbildende Schicht weist in der Regel eine Schichtdicke von 300 µm bis 6000 µm, bevorzugt 1000 µm bis 5000 µm auf. Selbstverständlich können eingesetzte Flexodruckelement auch mehrere fotopolymerisierbare, reliefbildende Schichten verschiedener Zusammensetzung übereinander umfassen.

Bei der digital bebilderbaren Schicht kann es sich beispielsweise um eine laserablatierbare Schicht, um eine mittels Ink-Jet-Drucker beschreibbare Schicht oder um eine thermographische Schicht handeln. Bevorzugt handelt es sich um eine laserablatierbare Schicht.

Die laserablatierbare Maskenschicht, auch LAMS-Schicht genannt, umfasst mindestens ein elastisches Bindemittel, insbesondere weichelastische Bindemittel. Selbstverständlich können auch Gemische mehrerer verschiedener Bindemittel eingesetzt werden. Beispiele geeigneter Bindemittel umfassen weichelastische Polyamide. Derartige Polyamide umfassen als monomere Bausteine langkettige, bifunktionelle Fettsäuren, die dem Polyamid weichelastische Eigenschaften verleihen. Weiterhin können Polyesteramide, Cellulosederivate, Nitrocellulose, Ethylenvinylacetatcopolymere, Polyacrylate oder Mischungen der genannten Polymere eingesetzt werden, sofern sie weichelastische Eigenschaften besitzen.

Die laserablatierbare Maskenschicht umfasst weiterhin UV/VIS-Licht absorbierende Materialien, wobei die Schichtdicke und/oder die Menge der lichtabsorbierenden Materialien in der Regel so bemessen werden, dass die optische Dichte der Schicht für UVA-Strahlung 2 bis 4 beträgt. Die hohe optische Dichte gewährleistet, dass die von der Maske bedeckten Bereiche der reliefbildenden Schicht im Zuge der vollflächigen Belichtung nicht polymerisieren.

Der UVA-Strahlungsbereich umfasst Licht der Wellenlänge von 300 nm bis 400 nm. Die optische Dichte ist die logarithmische Maßzahl für die Lichtundurchlässigkeit der Schicht in diesem Wellenlängenbereich. Bei der Messung der optischen Dichte wird daher kein Einzelwert der Lichtundurchlässigkeit bei einer bestimmten Wellenlänge ermittelt, sondern ein Mittelwert der Lichtundurchlässigkeiten in einem definierten Wellenlängenbereich. Üblicherweise erfolgt die Messung der optischen Dichte mittels kommerziell verfügbarer Densitometer (z.B. von x-rite), wobei der Wellenlängenbereich vor der Messung ausgewählt wird. Im Sinne der Erfindung beziehen sich alle zitierten Messwerte der optischen Dichte auf den UVA Bereich, d.h. den Bereich von 300 bis 400 nm.

Als lichtabsorbierendes Material eignet sich insbesondere feinteiliger Ruß. Ruß absorbiert auch sehr gut im IR-Bereich und gewährleistet somit bei der Bebilderung mittels IR-Laser gleichzeitig auch eine schnelle Bebilderung. Selbstverständlich kann die laserablatierbare Maskenschicht aber auch andere UV- oder IR- Absorber auf Pigmentbasis oder lösliche Farbstoffe enthalten. Ruß ist üblicherweise in einer Menge von 10 bis 50 Gew.-% bezüglich der Summer aller Komponenten enthalten.
Die Schichtdicke der Maskenschicht sollte einige wenige µm, bevorzugt 1 µm bis 4 µm betragen. Bei Schichtdicken unter 1 µm ist es schwierig, eine ausreichende optische Dichte zu erreichen. Bei Schichtdicken oberhalb von 3 µm ist die Laserempfindlichkeit des Elementes zu gering, so dass lange Laserzeiten zur Bebilderung notwendig sind. Die Laserempfindlichkeit der Maskenschicht (gemessen als die Energie, die notwendig ist, um 1 cm² Schicht zu ablatieren) sollte zwischen 1 und 4 mJ/cm² liegen, optimal ist ein Wert von etwa 2 mJ/cm².

### Erfindungsgemäße Vorrichtung

Die erfindungsgemäße Vorrichtung wird in Verfahren zur Verarbeitung plattenförmiger, digital bebilderbarer Flexodruckelemente zu Flexodruckplatten eingesetzt.

Mittels der erfindungsgemäßen Vorrichtung lassen sich mindestens die Verfahrensschritte Rückseitenbelichtung, Hauptbelichtung sowie Entwickeln automatisiert durchführen. Die Vorrichtung umfasst dementsprechend mindestens einen Modul zur Durchführung einer Rückseitenvorbelichtung, einen Modul zur Durchführung einer Hauptbelichtung und einen Modul zum Entwickeln belichteter Flexodruckelemente. Die Vorrichtung umfasst weiterhin eine Transporteinheit, mit der die Flexodruckelemente durch die Vorrichtung transportiert werden sowie eine Steuerungseinheit. Die Vorrichtung kann optional noch weitere Module zur Durchführung weiterer Verfahrensschritte umfassen.

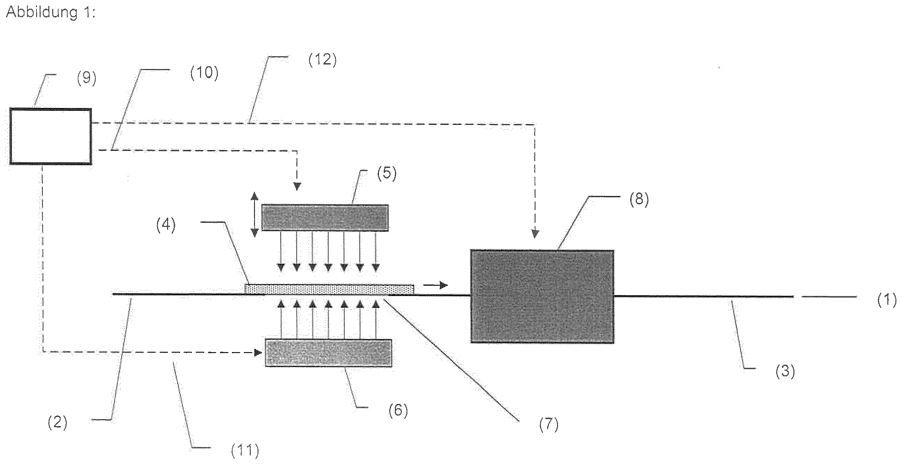

Abbildung 1 zeigt eine schematische Darstellung einer Ausführungsform der erfindungsgemäßen Vorrichtung.

Die Vorrichtung umfasst eine Transportvorrichtung (1), mit der die zu verarbeitenden Flexodruckelemente durch die Module der Vorrichtung transportiert werden. Die bereits digital bebilderten Flexodruckelemente werden am Anfang (2) der Transportvorrichtung in die Transportvorrichtung eingeführt und die verarbeiteten Flexodruckelemente können am Ende (3) der Transportvorrichtung entnommen werden. Der Begriff "digital bebildert" bedeutet, dass in die digital bebilderbare Schicht bereits eine Maske eingeschrieben wurde, d.h. das Flexodruckelement ist vorbereitet zur bildmäßigen Belichtung.

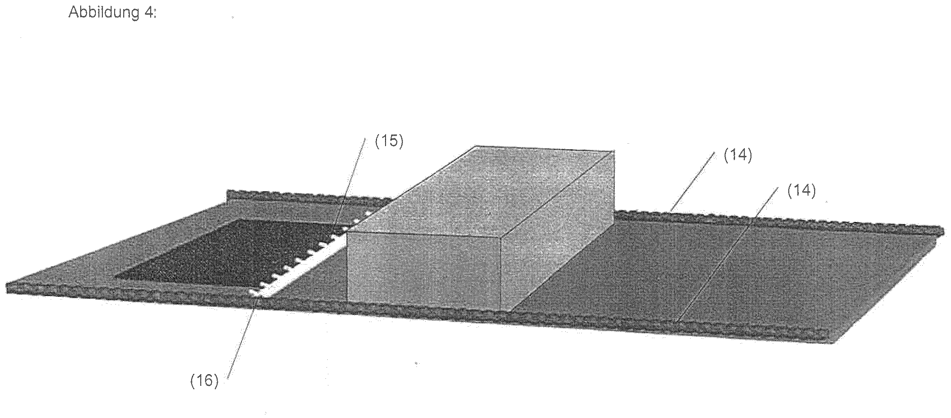

Eine Ausführungsform der Transportvorrichtung (1) ist in Abbildung 4 dargestellt.
Die dargestellte Transportvorrichtung (1) umfasst zwei parallel zueinander in einem Abstand a voneinander in Transportrichtung verlaufende Transportelemente (14). Hierbei kann es sich beispielsweise um umlaufende Transportketten, umlaufende Zahnriemen oder um rotierende Spindeln handeln, die jeweils von einer geeigneten Antriebseinheit angetrieben werden.
Die Transportvorrichtung (1) umfasst weiterhin Transportleisten (15), deren Länge mindestens a beträgt. Die Transportleisten können senkrecht zu den beiden Transportelementen mit ihren jeweiligen Enden (16) auf die beiden Transportelemente aufgelegt werden und werden mittels geeigneter Mitnehmer von den Transportelementen in Transportrichtung bewegt.

Die Art der Mitnehmer hängt dabei von der Art der Transportelemente ab. Handelt es sich um Ketten oder Zahnriemen können Mitnehmer, beispielsweise Stifte jeweils paarweise gegenüber angeordnet werden. Handelt es sich bei den Transportelementen um Spindeln, dann können die Mitnehmer in den seitlichen Enden der Transportleisten angeordnet sein.

Der Abstand a voneinander begrenzt die maximale Breite der Flexodruckelemente, welche mit der erfindungsgemäßen Vorrichtung verarbeitet werden können. Zu verarbeitende Flexodruckelemente können schmaler, aber nicht breiter sein als der Abstand a.

Die Transportvorrichtung kann weiterhin eine zwischen den beiden Transportelementen angeordnete Auflage aufweisen, auf der die Flexodruckelemente aufliegen. Die Auflage muss nicht durchgängig sein.

Zur Verarbeitung in der erfindungsgemäßen Apparatur werden die bebilderten Flexodruckelemente mit der in Transportrichtung vorderen Kante an einer Transportleiste befestigt und anschließend am Anfang (2) der Transportvorrichtung auf die beiden Transportelemente aufgelegt. Nach Durchlaufen durch die Vorrichtung können sie am Ende (3) wieder entnommen werden.

Das Befestigen der Flexodruckelemente kann beispielsweise erfolgen, indem man die belichteten Flexodruckelemente mittels einer externen oder einer in der Eingabevorrichtung integrierten Plattenstanze entlang der Einlaufkante locht und an dem Stanzbild entsprechend angeordneten Pins der Transportleiste einhängt. Bei der Transportleiste kann es sich in einer anderen Ausführungsform um eine Klemmleiste handeln, in die die Flexodruckelemente eingeklemmt werden können.

Die erfindungsgemäße Vorrichtung umfasst weiterhin eine oberhalb der Transportvorrichtung (1) angeordnete Hauptbelichtungseinheit (5) sowie eine unterhalb der Transportvorrichtung angeordnete Belichtungseinheit zur Rückseitenvorbelichtung (6). Die Auflage der Transportvorrichtung ist im Bereich der Rückseitenvorbelichtung (7) aus einem UV-transparenten Material gefertigt. In einer Ausführungsform der Erfindung ist die Hauptbelichtungseinheit höhenverstellbar, so dass der Abstand von Belichtungseinheit zu Plattenoberfläche variiert werden kann.

Im Bereich des Moduls "Rückseitenvorbelichtung" (7) kann die Transportvorrichtung eine Auflage aus einem UV-transparenten Material aufweisen, beispielsweise aus UVtransparentem Glas, Quarzglas oder PMMA.

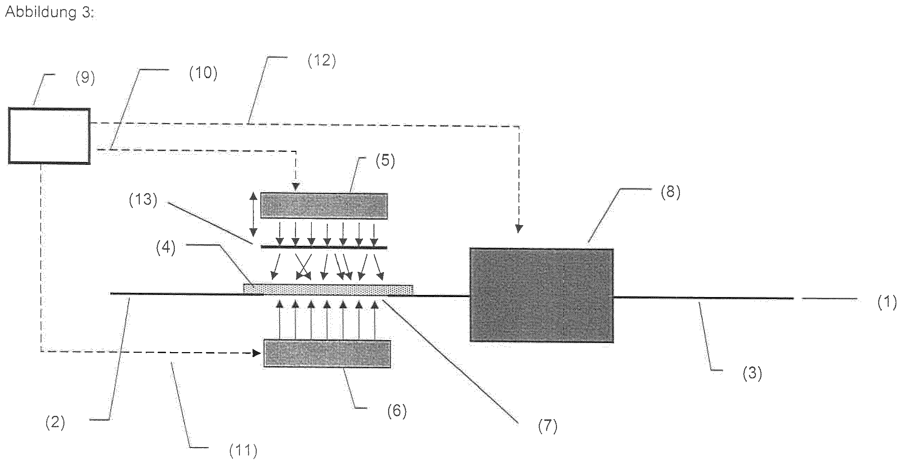

Bei den UV-Lichtquellen in der Hauptbelichtungseinheit (5) und der Einheit zur Rückseitenvorbelichtung (6) kann es sich prinzipiell um beliebige Lichtquellen handeln, beispielsweise UV-Röhren oder UV-LEDs, wobei UV-LEDs in prinzipiell bekannter Art und Weise in Form von Diodenarrays angeordnet sind. Erfindungsgemäß ist die Leistung der UV-Lichtquellen regelbar. Bevorzugt handelt es sich um UV-LEDs. In einer Ausführungsform kann die Hauptbelichtungseinheit eine Diffusionsscheibe (13) umfassen (siehe Abbildung 3). Hierdurch lässt sich UV-Licht streuen und die bestrahlte Fläche vergrößern oder die Gleichmäßigkeit der Strahlungsintensität über der bestrahlten Fläche verbessern.

Der Abstand zwischen der Oberfläche des Flexodruckelements und UV-LEDs kann klein gehalten werden und beträgt üblicherweise 2 bis 100 mm, bevorzugt 2 bis 20 mm und beispielsweise 2 bis 10 mm. Die Strahlung von UV-LEDs weist praktisch keinen IR-Anteil auf, so dass auch eine hohe Intensität bei einem geringen Abstand zum Flexodruckelement möglich ist, ohne dass eine zu hohe Wärmebelastung des Flexodruckelements zu befürchten ist.

Bei anderen UV-Quellen müssen aufgrund der IR-Anteile in der emittierten Strahlung naturgemäß größere Abstände eingehalten werden.

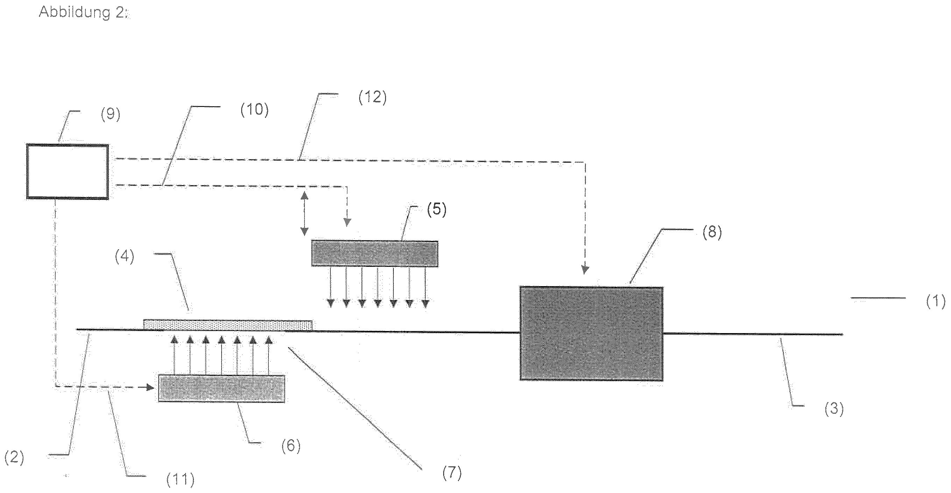

Die Hauptbelichtungseinheit (5) und die Einheit zur Rückseitenvorbelichtung (6) können wie in Abbildung 1 dargestellt einander gegenüber liegend angeordnet sein, so dass Hauptbelichtung und Rückseitenvorbelichtung gleichzeitig erfolgen. In einer weiteren, in Abbildung 2 dargestellten Ausführungsform der erfindungsgemäßen Vorrichtung kann die Einheit zur Rückseitenvorbelichtung (6) vor der Hauptbelichtung (5) angeordnet werden. Die Belichtung sollte zur Vermeidung von Streulichteffekten in den Randbereichen des Flexodruckelements nur in der Breite des Flexodruckelements erfolgen. Vorteilhaft weist der Belichter daher Blenden auf, welche die Belichtungsbreite auf die Breite des Flexodruckelements reduzieren.

Die erfindungsgemäße Vorrichtung umfasst weiterhin eine Entwicklungseinheit (8). Die Einheit ist so angeordnet, dass ein bildmäßig belichtetes Flexodruckelement nach Rückseitenvorbelichtung und Hauptbelichtung in die Entwicklungseinheit (8) eintritt. In der Entwicklungseinheit werden die Reste der digital bebilderbaren Schicht, beispielsweise der Reste der laserablatierbaren Maskenschicht sowie der nicht polymerisierten Anteile der reliefbildenden Schicht entfernt. Sofern das eingesetzte Flexodruckelement noch weitere, oberhalb der reliefbildenden Schicht angeordnete Schichten umfasst, werden diese ebenfalls entfernt.

In einer bevorzugten Ausführungsform der Erfindung handelt es sich bei der Entwicklungseinheit (8) um eine Auswascheinheit (8a) zum Entfernen der Reste der digital bebilderbaren Schicht sowie der nicht polymerisierten Anteile der reliefbildenden Schicht unter Verwendung von Auswaschmitteln.

Die Auswascheinheit kann hierzu in üblicher Art und Weise eine Wanne zur Aufnahme der Auswaschmittel, Zu- und Abläufe für Auswaschmittel sowie Auswaschbürsten umfassen. Im Bereich unterhalb der Bürsten ist vorteilhaft eine Auflage für die Flexodruckelemente angebracht, beispielsweise ein Lochblech. Die auszuwaschenden Flexodruckelemente können mittels der geschilderten Transportvorrichtung durch die Wanne gezogen werden. Die Auswaschbürsten dienen zur mechanischen Unterstützung des Auswaschvorganges.

In einer weiteren Ausführungsform der Erfindung handelt es sich bei der Entwicklungseinheit (8) um eine Einheit zum thermischen Entwickeln (8b), d.h. zum thermischen Entfernen der Reste der digital bebilderbaren Schicht sowie der nicht polymerisierten Anteile der reliefbildenden Schicht.

Die thermische Entwicklungseinheit umfasst hierbei in prinzipiell bekannter Art und Weise Baueinheiten zum Erwärmen der reliefbildenden Schicht sowie Baueinheiten zum Kontaktieren der Oberseite der erwärmten reliefbildenden Schicht mit einem saugfähigen Material zur Aufnahme schmelzflüssigen fotopolymeriserbaren Materials. Bei den Baueinheiten zum Erwärmen kann es sich um eine erwärmbare Unterlage für das Flexodruckelement und/oder oberhalb der reliefbildenden Schicht angeordnete IR-Strahler handeln. Das saugfähige Material kann beispielsweise mithilfe einer optional beheizbaren Platte auf die Oberfläche des Flexodruckelements gepresst werden.

Erfindungsgemäß umfasst die Vorrichtung weiterhin eine Steuerungseinheit (9). Mit der Steuerungseinheit lässt sich jeweils die Leistung der Einheit zur Rückseitenvorbelichtung (6) und der Hauptbelichtungseinheit (5) steuern. Weiterhin lassen sich auch die Geschwindigkeit der Transportvorrichtung und damit die Entwicklungszeit, beispielsweise die Auswaschzeit des Flexodruckelements regeln.

Selbstverständlich können optional auch noch weitere Funktionen der Vorrichtung durch die Steuerungseinheit gesteuert werden.

Die erfindungsgemäße Vorrichtung kann optional noch weitere Baueinheiten umfassen.

### Erfindungsgemäßes Verfahren

Für das erfindungsgemäße Verfahren wird als Ausgangsmaterial ein digital bebilderbares Flexodruckelement umfassend mindestens eine UV-transparente, dimensionsstabile Trägerfolie, eine fotopolymerisierbare, reliefbildende Schicht sowie eine digital bebilderbare Schicht eingesetzt und zu einer druckfertigen Flexodruckform verarbeitet. Das Verfahren umfasst in prinzipiell bekannter Art und Weise mindestens die folgenden Verfahrensschritte:
(A) Einschreiben einer Maske in die digital bebilderbare Schicht,
(B) Rückseitenvorbelichtung des bebilderten Flexodruckelements mit UV-Strahlung durch die UV-transparente Trägerfolie hindurch,
(C) Belichten des bebilderten Flexodruckelements mit UV-Strahlung durch die gebildete Maske hindurch,
(D) Entfernen der Reste der digital bebilderbaren Schicht sowie der nicht polymerisierten Anteile der reliefbildenden Schicht.

Erfindungsgemäß werden mindestens die Verfahrensschritte (B), (C) und (D) mit der oben beschriebenen Vorrichtung umfassend mindestens ein Modul zur Durchführung einer Rückseitenvorbelichtung, ein Modul zur Durchführung einer Hauptbelichtung, ein Modul zur Entwickeln belichteter Flexodruckelemente, eine Transporteinheit sowie eine Steuerungseinheit durchgeführt.

Optional kann das Verfahren selbstverständlich noch weitere Verfahrensschritte umfassen. Verfahrensschritt (A) wird in der Regel in einem separaten, vorangehenden Schritt durchgeführt. Apparaturen zum Bebildern digital bebilderbarer Flexodruckelemente sind dem Fachmann prinzipiell bekannt.

Zur Durchführung des erfindungsgemäßen Verfahrens wird ein digital bebildertes Flexodruckelement an der Eingabevorrichtung (3) mit Transportleiten verbunden und in die Transportvorrichtung (1) eingelegt. Mittels der Vorrichtung wird das bebilderte Flexodruckelement in Richtung der Module zur Rückseitenvorbelichtung, Hauptbelichtung sowie zum Entwickeln bewegt.

In einer bevorzugten Ausführungsform der Erfindung nimmt man Verfahrensschritt (D) unter Verwendung eines Auswaschmittels vor, d.h. die nicht belichteten Anteile der reliefbildenden Schicht werden in einem geeigneten Auswaschmittel gelöst. Hierzu wird eine Vorrichtung mit einer Auswascheinheit (8a) eingesetzt. Bei dieser Ausführungsform wird die erhaltene Flexodruckplatte in einem weiteren Verfahrensschritt (E) getrocknet. Optional kann die Oberfläche der getrockneten Flexodruckplatte in einem weiteren Verfahrensschritt (F) mit UV-A und/oder UV-C-Licht nachbehandelt werden.
Zur Durchführung der Schritte (E) und optional (F) können die ausgewaschenen Flexodruckplatten über die Ausgabeeinheit (3) der erfindungsgemäßen Vorrichtung entnommen werden, und die Schritte (E) und (F) werden in prinzipiell bekannter Art und Weise durchgeführt.

In einer weiteren Ausführungsform der Erfindung nimmt man Verfahrensschritt (D) thermisch vor. Hierzu wird eine Vorrichtung mit einer thermischen Entwicklungseinheit (8b) eingesetzt. Bei dieser Ausführungsform werden die nicht polymerisierten Anteile der reliefbildenden Schicht einschließlich der Reste der digital bebilderbaren Schicht bis zur Schmelzflüssigkeit erwärmt, die Oberfläche der reliefbildenden Schicht mindestens einmal mit einem saugfähigen Material in Kontakt gebracht, die schmelzflüssigen, nicht polymerisierten Anteile der reliefbildenden Schicht mittels des saugfähigen Materials aufgesogen und der Kontakt des saugfähigen Materials mit der Oberfläche der reliefbildenden Schicht wieder gelöst.

Die Geschwindigkeit, mit der das Flexodruckelement von der Transportvorrichtung transportiert wird, wird über die Steuerungseinheit (9) eingestellt, und zwar entsprechend der erforderlichen Entwicklungsgeschwindigkeit, also der Geschwindigkeit des Auswaschens oder des thermischen Entwickelns.
Die Entwicklungsgeschwindigkeit wird so gewählt, dass gerade ein vollständiges Entfernen der nicht polymerisierten Anteile der reliefbildenden Schicht möglich ist. Selbstverständlich kann auch eine noch geringere Entwicklungsgeschwindigkeit gewählt werden, aber dies ist aus ökonomischen Gründen nicht sinnvoll. Die Entwicklungsgeschwindigkeit für ein Flexodruckelement richtet sich im Wesentlichen nach der Dicke des Flexodruckelements, dessen Aufbau und -beim Auswaschen mittels Auswaschmittel- der Art und Temperatur des verwendeten Auswaschmittels oder -beim thermischen Entwickeln- der Entwicklungstemperatur. Die Bedingungen werden vom Fachmann entsprechend gewählt. Für kommerziell erhältliche Flexodruckelemente existieren Tabellen mit empfohlenen Auswaschgeschwindigkeiten, ansonsten lassen sich die optimalen Auswaschgeschwindigkeiten vom Fachmann leicht bestimmen. Entsprechendes gilt für thermisches Entwickeln.

In der Regel liegt die Transportgeschwindigkeit - abhängig von der Plattendicke - bei 50 mm/min bis 900 mm/min. Der minimale Wert von 50 mm/min kann beim Entwickeln sehr dicker Platten notwendig sein, während dünne Platten u.U. mit bis zu 900 mm/min entwickelt bzw. ausgewaschen werden können.

Aufgrund der eingestellten Transportgeschwindigkeit ist die Zeit, die das Flexodruckelement benötigt, um die Module zur Rückseitenvorbelichtung und zur Hauptbelichtung zu passieren, fixiert, und damit ist auch zwangsläufig die Belichtungszeit fixiert. Wie gesehen können sich die Transportgeschwindigkeiten um den Faktor 10 unterscheiden, und dementsprechend können auch die Belichtungszeiten um den Faktor 10 unterschiedlich sein.

Erfindungsgemäß wird mittels der Steuerungseinheit (9) die Leistung der UV-Quellen zur Rückseitenvorbelichtung und zur Hauptbelichtung entsprechend der fixierten Belichtungszeit so angepasst, dass eine zufriedenstellende bildmäßige Vernetzung der reliefbildenden Schicht stattfindet.

## Patentansprüche

1. Vorrichtung zur Herstellung von Flexodruckplatten ausgehend von digital bebilderten Flexodruckelementen umfassend mindestens eine UV-transparente, dimensionsstabile Trägerfolie, eine fotopolymerisierbare, reliefbildende Schicht sowie eine digital bebilderte Schicht umfassend mindestens
• eine Transportvorrichtung (1) zum Transportieren der Flexodruckelemente durch die Vorrichtung,
• eine unterhalb der Transportvorrichtung angeordnete Belichtungseinheit (6) zur Rückseitenvorbelichtung der Flexodruckelemente mittels UV-Strahlung, umfassend mindestens eine in der Leistung regelbare UV-Quelle,
• eine oberhalb der Transportvorrichtung angeordnete Belichtungseinheit (5) zur Hauptbelichtung der Flexodruckelemente mittels UV-Strahlung, umfassend mindestens eine in der Leistung regelbare UV-Quelle, mit der Maßgabe, dass die Belichtungseinheit (5) in Transportrichtung hinter der Belichtungseinheit (6) angeordnet ist oder dass die Belichtungseinheiten (5) und (6) einander gegenüber liegend angeordnet sind,
• eine in Transportrichtung hinter den Belichtungseinheiten angeordnete Entwicklungseinheit (8b) zum thermischen Entfernen der Reste der digital bebilderten Schicht sowie der nicht polymerisierten Anteile der reliefbildenden Schicht,
• eine Steuerungseinheit (9) zum Regeln der Leistung der Belichtungseinheit (6) zur Rückseitenvorbelichtung, der Leistung der Belichtungseinheit (5) zur Hauptbelichtung und der Transportgeschwindigkeit der Transportvorrichtung (1).

2. Vorrichtung gemäß Anspruch 1, **dadurch gekennzeichnet, dass** es sich bei der UV-Quelle in der Einheit (5) zur Hauptbelichtung um UV-LEDs handelt.

3. Vorrichtung gemäß Anspruch 1 oder 2, **dadurch gekennzeichnet, dass** es sich bei der UV-Quelle in der Belichtungseinheit (6) zur Rückseitenvorbelichtung um UV-LEDs handelt.

4. Vorrichtung gemäß einem der Ansprüche 1 bis 3, **dadurch gekennzeichnet, dass** die Belichtungseinheit (5) höhenverstellbar ist.

5. Verfahren zur Herstellung von Flexodruckplatten ausgehend von digital bebilderbaren Flexodruckelementen umfassend mindestens eine UV-transparente, dimensionsstabile Trägerfolie, eine fotopolymerisierbare, reliefbildende Schicht sowie eine digital bebilderbare Schicht umfassend mindestens die folgenden Verfahrensschritte:
(A) Einschreiben einer Maske in die digital bebilderbare Schicht,
(B) Rückseitenvorbelichtung des bebilderten Flexodruckelements mit UV-Strahlung durch die UV-transparente Trägerfolie hindurch,
(C) Belichten des bebilderten Flexodruckelements mit UV- Strahlung durch die gebildete Maske hindurch,
(D) Entfernen der Reste der digital bebilderbaren Schicht sowie der nicht polymerisierten Anteile der reliefbildenden Schicht, indem man
• die nicht polymerisierten Anteile der reliefbildenden Schicht einschließlich der Reste der digital bebilderbaren Schicht bis zur Schmelzflüssigkeit erwärmt,
• die Oberfläche der reliefbildenden Schicht mindestens einmal mit einem saugfähigen Material in Kontakt bringt,
• die schmelzflüssigen, nicht polymerisierten Anteile der reliefbildenden Schicht mittels des saugfähigen Materials aufsaugt, und
• den Kontakt des saugfähigen Materials mit der Oberfläche der reliefbildenden Schicht wieder löst,
**dadurch gekennzeichnet, dass** man mindestens die Verfahrensschritte (B), (C) und (D) unter Verwendung einer Vorrichtung gemäß einem der Ansprüche 1 bis 4 durchführt, wobei man die Geschwindigkeit der Transportvorrichtung mittels der Steuerungseinheit (9) auf einen festen Wert einstellt und die Leistung der UV-Quelle zur Rückseitenvorbelichtung sowie die Leistung der UV-Quelle zur Hauptbelichtung entsprechend der gewählten Transportgeschwindigkeit einstellt.

## Claims

1. Device for producing flexographic printing plates starting from digitally imaged flexographic printing elements, comprising at least one UV-transparent, dimensionally stable support sheet, a photopolymerizable, relief-forming layer, and a digitally imaged layer, comprising at least
• a transport device (1) for transporting the flexographic printing elements through the device,
• an exposure unit (6) disposed beneath the transport device, for the preliminary exposure of flexographic printing elements from the reverse by means of UV radiation, comprising at least one UV source regulatable in its power,
• an exposure unit (5) disposed above the transport device, for the main exposure of flexographic printing elements by means of UV radiation, comprising at least one UV source regulatable in its power, with the proviso that the exposure unit (5) is disposed after the exposure unit (6) in the transport direction, or that the exposure units (5) and (6) are disposed opposite one another,
• a developing unit (8b) disposed after the exposure units in the transport direction, for thermally removing the residues of the digitally imaged layer and also the unpolymerized fractions of the relief-forming layer,
• a control unit (9) for regulating the power of the exposure unit (6) for preliminary reverse exposure, the power of the exposure unit (5) for main exposure, and the transport speed of the transport device (1).

2. Device according to Claim 1, **characterized in that** the UV source in the unit (5) for main exposure comprises UV-LEDs.

3. Device according to Claim 1 or 2, **characterized in that** the UV source in the exposure unit (6) for preliminary reverse exposure comprises UV-LEDs.

4. Device according to any of Claims 1 to 3, **characterized in that** the exposure unit (5) is height-adjustable.

5. Method for producing flexographic printing plates starting from digitally imagable flexographic printing elements, comprising at least one UV-transparent, dimensionally stable support sheet, a photopolymerizable, relief-forming layer, and a digitally imagable layer, comprising at least the following method steps:
(A) writing a mask into the digitally imagable layer,
(B) preliminary reverse exposure of the imaged flexographic printing element with UV radiation through the UV-transparent support sheet,
(C) exposing the imaged flexographic printing element with UV radiation through the mask formed,
(D) removing the residues of the digitally imagable layer and also the unpolymerized fractions of the relief-forming layer, wherein
• the unpolymerized fractions of the relief-forming layer, including the residues of the digitally imagable layer, are heated to a liquid-melt state,
• the surface of the relief-forming layer is contacted at least once with an absorbent material,
• the unpolymerized, liquid-melt fractions of the relief-forming layer are absorbed by means of the absorbent material, and
• the contact between the absorbent material and the surface of the relief-forming layer is discontinued,
**characterized in that** at least method steps (B), (C), and (D) are carried out using a device according to any of Claims 1 to 4, the speed of the transport device being set at a fixed value by means of the control unit (9), and the power of the UV source for preliminary reverse exposure and also the power of the UV source for main exposure being set in accordance with the selected transport speed.

## Revendications

1. Dispositif de fabrication de clichés flexographiques à partir d'éléments flexographiques illustrés numériquement comprenant au moins un film porteur aux dimensions stables, transparent aux UV, une couche formant des reliefs photopolymérisable ainsi qu'une couche illustrée numériquement comprenant au moins
• un dispositif de transport (1) pour transporter les éléments flexographiques à travers le dispositif,
• une unité d'exposition (6) disposée au-dessous du dispositif de transport à des fins de préexposition du côté arrière des éléments flexographiques au moyen d'un rayonnement UV, comprenant au moins une source d'UV pouvant être réglée en puissance,
• une unité d'exposition (5) disposée au-dessus du dispositif de transport à des fins d'exposition principale des éléments flexographiques au moyen d'un rayonnement UV, comprenant au moins une source d'UV pouvant être réglée en puissance, avec la condition que l'unité d'exposition (5) soit disposée derrière l'unité d'exposition (6) dans la direction de transport ou que les unités d'exposition (5) et (6) soient disposées en venant reposer l'une sur l'autre,
• une unité de développement (8b) disposée derrière les unités d'exposition dans la direction de transport à des fins d'élimination thermique des restes de l'image illustrée numériquement ainsi que des portions non polymérisées de la couche formant des reliefs,
• une unité de commande (9) pour régler la puissance de l'unité d'exposition (6) à des fins de préexposition du côté arrière, la puissance de l'unité d'exposition (5) à des fins d'exposition principale et la vitesse de transport du dispositif de transport (1).

2. Dispositif selon la revendication 1, **caractérisé en ce que** la source d'UV dans l'unité (5) pour l'exposition principale consiste en des LEDs UV.

3. Dispositif selon la revendication 1 ou 2, **caractérisé en ce que** la source d'UV dans l'unité d'exposition (6) pour la préexposition du côté arrière consiste en LEDs UV.

4. Dispositif selon une des revendications 1 à 3, **caractérisé en ce que** l'unité d'exposition (5) peut être réglée en hauteur.

5. Procédé de fabrication de clichés flexographiques à partir d'éléments flexographiques illustrés numériquement comprenant au moins un film porteur aux dimensions stables, transparent aux UV, une couche formant des reliefs photopolymérisable ainsi qu'une couche pouvant former une image numérique comprenant au moins les étapes de procédé suivantes :
(A) inscription d'un masque dans la couche pouvant former une image numérique,
(B) préexposition du côté arrière de l'élément flexographique illustré avec un rayonnement UV à travers le film porteur transparent aux UV,
(C) exposition de l'élément flexographique illustré avec un rayonnement UV à travers le masque formé,
(D) élimination des restes de la couche pouvant former une image numérique ainsi que des portions non polymérisées de la couche formant des reliefs, en
• réchauffant les portions non polymérisées de la couche formant des reliefs en incluant les restes de la couche pouvant former une image numérique jusqu'à la fusion liquide,
• amenant en contact la surface de la couche formant des reliefs au moins une fois avec un matériau absorbant,
• aspirant les portions en fusion liquide, non polymérisées de la couche formant des reliefs au moyen du matériau absorbant, et
• annulant de nouveau le contact du matériau absorbant avec la surface de la couche formant des reliefs,
**caractérisé en ce que** on effectue au moins les étapes de procédé (B), (C) et (D) en utilisant un dispositif selon une des revendications 1 à 4, dans lequel on règle la vitesse du dispositif de transport au moyen de l'unité de commande (9) sur une valeur fixe et on règle la puissance de la source UV à des fins de préexposition du côté arrière ainsi que la puissance de la source UV à des fins d'exposition principale de manière correspondante à la vitesse de transport sélectionnée.
